# EUROPÄISCHE PATENTSCHRIFT

(11) **EP 2 358 615 B1**
(45) Veröffentlichungstag und Bekanntmachung des Hinweises auf die Patenterteilung: **31.07.2013**
(21) Anmeldenummer: 09803998.5
(22) Anmeldetag: 26.11.2009
(51) Int. Cl.: B65G 49/06

(54) **VERFAHREN UND VORRICHTUNG ZUM SCHNELLTRANSPORT VON GLASPLATTEN**
PROCESS AND APPARATUS TO QUICKLY TRANSPORT SHEETS OF GLASS
PROCÉDÉ ET APPAREIL POUR TRANSPORTER RAPIDEMENT DES FEUILLES DE VERRE

(30) Priorität: 17.12.2008 DE 102008062153
(43) Veröffentlichungstag der Anmeldung: 24.08.2011
(73) Patentinhaber: Grenzebach Maschinenbau GmbH, 86663 Asbach-Bäumenheim (DE)
(72) Erfinder: ROSSMANN, Thomas, 86690 Merlingen (DE)
(74) Vertreter: Karl, Frank
(86) Internationale Anmeldenummer: PCT/DE2009/001677
(87) Internationale Veröffentlichungsnummer: WO 2010/075830

(56) Entgegenhaltungen:
- WO-A1-2005/002804
- WO-A1-2007/091503
- DE-A1- 2 602 622
- DE-A1- 4 000 081
- DE-A1- 10 138 619
- DE-A1- 10 142 395
- DE-A1-102004 045 517
- DE-B- 1 292 581
- DE-U1-202005 013 680
- JP-A- 7 010 267
- JP-A- 2001 253 536

## Beschreibung

Die Erfindung betrifft ein Verfahren und eine Vorrichtung zum Schnelltransport von Glasplatten zwischen verschiedenen Fertigungs-Stationen in einer großräumigen Fertigungsanlage sowie ein Computerprogramm und einen maschinenlesbaren Träger zur Durchführung des Verfahrens. Hier ist zum Beispiel an die Fertigung von photovoltaischen Elementen zu denken.

Aus der DE 84 29 202 U1 ist zum Stand der Technik ein stapelbares Lager- und Transportgestell für Profilglasbahnen bekannt, welches ein Transportsystem zum Lagern, Verladen und Transportieren von U-Profilglasbahnen, bestehend aus zwei u-förmigen Metallrahmen, in die unter Zwischenschaltung elastischer Zwischenlagen die Profilglasbahnen hochkant eingesetzt werden, schaffen soll, das keine schädlichen Druckkräfte auf die Glasbahnen ausübt.

Hierzu wird vorgeschlagen, dass am Bodenteil jedes u-förmigen Metallrahmens parallel zu dem waagrechten Metallprofil ein, eine Auflagefläche für die Profilglasrahmen und eine Einstecktasche für einen Gabelzinken eines Gabelstaplers bildendes Winkelprofil angeordnet ist. Weiter sind an den die Seitenteile der u-förmigen Metallrahmen bildenden vertikalen Winkelprofilen im oberen Bereich mit einem Distanzbügel zusammenwirkende Rohrhülsen angeordnet.

Hinweise für den Schnelltransport von Glasplatten in einer großräumigen Fertigungsanlage sind dieser Druckschrift nicht zu entnehmen.

Aus der DE 15 56 146 A1 ist ein Verfahren zum Transport eines tafelförmigen Stückes aus einer ersten Stellung in eine zweite Stellung bekannt. Gemäß diesem Verfahren wird in der ersten Stellung ein beträchtlicher Unterdruck auf die obere Fläche des tafelförmigen Stückes ausgeübt, um dieses an einem beweglichen Saugglied durch Haftwirkung zu halten. Ferner wird während der Bewegung des Stückes in die zweite Stellung ein geringerer Unterdruck auf die obere Fläche aufrechterhalten und dann das Stück mechanisch von dem beweglichen Saugglied getrennt, um Außenluft auf seine obere Fläche zu leiten, sodass das Stück in die gewünschte zweite Stellung fällt.

Auch aus dieser Druckschrift sind keine Hinweise für den Schnelltransport von Glasplatten in einer großräumigen Fertigungsanlage zu entnehmen.

Aus der DE 12 92 581 A ist ein Stapelhubgerät in der Ausbildung als Regalstapelgerät, das sich über Rollen gegen Schienen am Regal abstützt, bekannt. Dieses Gerät weist einen mittels Hubketten betreibbaren Hubschlitten und eine mittels einer Druckmittelpresse betätigbare Kurzhubvorrichtung auf. Alle Verrichtungen werden hierbei per Hand betrieben. Außerdem stützt sich dieses Stapelhubgerät am zugehörigen Regal ab und ist somit nicht frei verfahrbar. Außer bekannten Funktionsprinzipien der Hubtechnik ist dieser Druckschrift kein Hinweis für eine Anwendung in einer modernen Fertigungsanlage zur Fertigung von photovoltaischen Elementen unter Reinraumbedingungen zu entnehmen.

In der DE 101 38 619 A1 ist eine Vorrichtung zum Transportieren, Entnehmen und Belegen von Werkstückträgern beschrieben. Bei dieser Vorrichtung ist es nach den Angaben in der Beschreibung von wesentlicher Bedeutung, dass eine Auszugsvorrichtung eigenständig angetrieben, von einer Hebeeinrichtung selbständig, vorzugsweise zwischen C-Profile von Lagersystemen, einfahrbar ist, wobei die Hebeeinrichtung vollständig verlassen wird.

Außer auf der Hand liegender Vorteile ist dieser Druckschrift mit ihren aufgabenhaft formulierten Ansprüchen keine verwertbare Lehre zu entnehmen.

Aus der DE 20 2005 013 680 U1 ist ein Regalfahrzeug für Behälterlager zur Bewegung des Regalfahrzeugs entlang einer Regalfront bekannt mit Lastaufnahmemitteln, die vertikal verfahrbar sind und in Regaltiefenrichtung zwischen einer mittleren Transportposition und einer ausgefahrenen Übergabeposition verfahrbar sind. Um die zum Ein- und Auslagern von Behältern erforderlichen Spielzeiten zu verringern wird in dieser Druckschrift im Wesentlichen gelehrt, eine Steuereinrichtung vorzusehen, die die nötigen Vorgänge steuert.
Eine Anregung zur Lösung der der Erfindung zugrunde liegenden Aufgabe ist hier nicht zu erkennen.

In der DE 10 2004 045 517 A1 ist ein System beschrieben, welches den erforderlichen Aufwand für die Stromversorgung bei diesem System, bestehend aus mindestens einer verfahrbaren Funktionseinrichtung und mehreren stationären Funktionseinrichtungen mit jeweils einem elektrischen Verbraucher, der über eine Stromversorgung speisbar ist, vermindern soll. In dieser Druckschrift findet sich der Hinweis auf die bekannte Maßnahme, eine Stromversorgung auf induktivem Weg zu gestalten. Eine Anregung darauf, diese Maßnahme in der erfindungsgemäßen Vorrichtung vorzunehmen, ist der DE 10 2004 045 517 A1 nicht zu entnehmen.

Die DE 21 54 709 A1 offenbart ein Regalförderfahrzeug zur Bedienung von Hochregalen, in deren Gängen je ein mit Hubmitteln ausgestatteter Hubmast horizontal verfahrbar vorgesehen ist. Zur Reduzierung von Raumverlusten sind hier an einem Hubmast wenigstens zwei vertikal verfahrbare Hubwagen vorgesehen. Eine wesentliche Bereicherung des Standes der Technik im Hinblick auf die erfindungsgemäße Vorrichtung ist hier nicht erkennbar.

In der EP 1 254 852 A1 ist ein Lager und Transportsystem mit einer oder mehreren Regalzeilen zur Aufnahme von Lagergut in mehreren Regalebenen, einer Vielzahl von Schienenwegen und mehreren schienengebundenen Fahrzeugen beschrieben, bei dem der Volumennutzungsgrad erhöht werden soll und eine einfache und kostengünstige Erweiterung zur Erhöhung der Kapazität ermöglich werden soll. Hierzu sind in dieser Druckschrift im Wesentlichen Mittel zur kabellosen externen Energieversorgung der Fahrzeuge während ihres Betriebs vorgesehen, Mittel zur Aufgabe und Abgabe des Lagerguts der einzelnen Fahrzeuge über eine Funkverbindung ausgebildet und die Fahrzeuge mit einem Empfangssystem zum Empfang und zur Umsetzung der von einem Steuerrechner übermittelten Steuersignale ausgestattet. Ein Hinweis darauf, diese Maßnahme in der erfindungsgemäßen Vorrichtung vorzunehmen, ist der EP 1 254 852 A1 nicht zu entnehmen.

In der DE 40 00 081 A1 ist eine Weichensteuerung für ein selbstfahrendes Bodenfördererfahrzeug offenbart. Der Merkmalsgehalt dieser Druckschrift betrifft die erfindungsgemäße Vorrichtung nur am Rand und bietet keinen Hinweis auf die Lösung der, der Erfindung zugrunde liegenden, Aufgabe.

Die DE 199 10 478 C2 betrifft ein Verfahren zum Transportieren eines Substrats unter Verwendung einer Substrattransportvorrichtung. Hierbei handelt es sich um den Transport relativ kleiner Wafer, während es sich bei der Erfindung um den Schnelltransport von vergleichsweise großen Glasplatten handelt. Die dort offenbarten Gleitabdeckungen reduzieren die Emission von Partikeln beträchtlich und sind dort notwendig.

Ein Hinweis darauf, eine vergleichbare Maßnahme in der erfindungsgemäßen Vorrichtung vorzunehmen, ist der DE 199 10 478 C2 nicht zu entnehmen.

Die Druckschrift JP 07 010267 A1 offenbart ein Übergabe-Bauteil zum Einsatz in Reinräumen, mit dem plattenförmige Glassubstrate gehalten, positioniert und platziert werden können. Hierzu weist das Übergabe-Bauteil eine Hebeeinrichtung auf zum vertikalen Anheben des Glassubstrats von einem auf Schienen geführten Transportvehikel, sowie eine vertikal und horizontal verfahrbare Handplatte.

Die DE 101 42 395 A1 betrifft ein Lager- und Transportsystem in modularer Bauweise.

Der Erfindung liegt deshalb die Aufgabe zugrunde, eine Transportvorrichtung und ein Verfahren zum Transport von Glasplatten zu schaffen, die die Glasplatten auf beiden Seiten ihres Transportweges stapelweise sicher aufnehmen, schnell und weit transportieren und auf beiden Seiten des Transportweges sicher absetzen kann, wobei die Energiezuführung kabellos erfolgt und Reinraumbedingungen eingehalten werden müssen, sowie ein Computerprogramm und einen maschinenlesbaren Träger zur Durchführung des Verfahrens.

Diese Aufgabe wird hinsichtlich der Vorrichtung durch die Merkmale nach Anspruch 1, hinsichtlich des Verfahrens durch die Maßnahmen nach Anspruch 5, hinsichtlich des Computerprogramms durch die Merkmale des Anspruchs 8 und bezüglich des maschinenlesbaren Trägers durch die Merkmale des Anspruchs 9 gelöst.

Weitere vorteilhafte Ausgestaltungen der Erfindung ergeben sich aus den Unteransprüchen.

Die erfindungsgemäße Vorrichtung wird im Folgenden näher beschrieben. Es zeigen im Einzelnen:
- Fig.1:: eine perspektivische Darstellung einer erfindungsgemäßen Transportvorrichtung,
- Fig.2:: einen ersten Querschnitt des Hubportals,
- Fig.3:: einen zweiten Querschnitt des Hubportals,
- Fig.4:: eine Draufsicht auf das Hubportal,
- Fig.5:: einen Detail-Querschnitt des Hubportals,
- Fig.6:: eine perspektivische Übersichtsdarstellung des Funktionsbereichs einer erfindungsgemäßen Transportvorrichtung

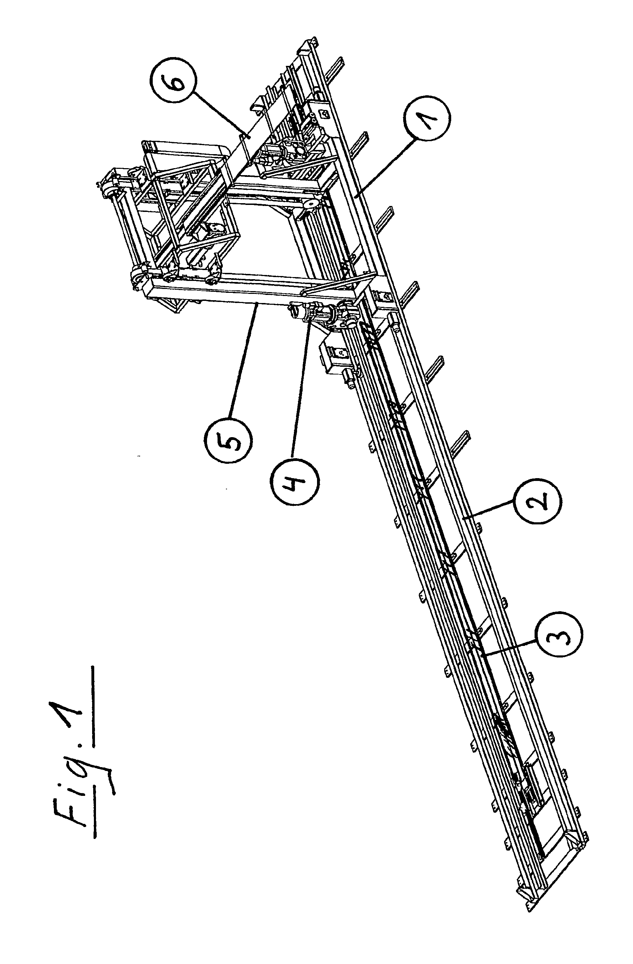

Die Fig.1 zeigt eine perspektivische Darstellung einer erfindungsgemäßen Transportvorrichtung ohne eine Belade-Station oder Entlade-Station.

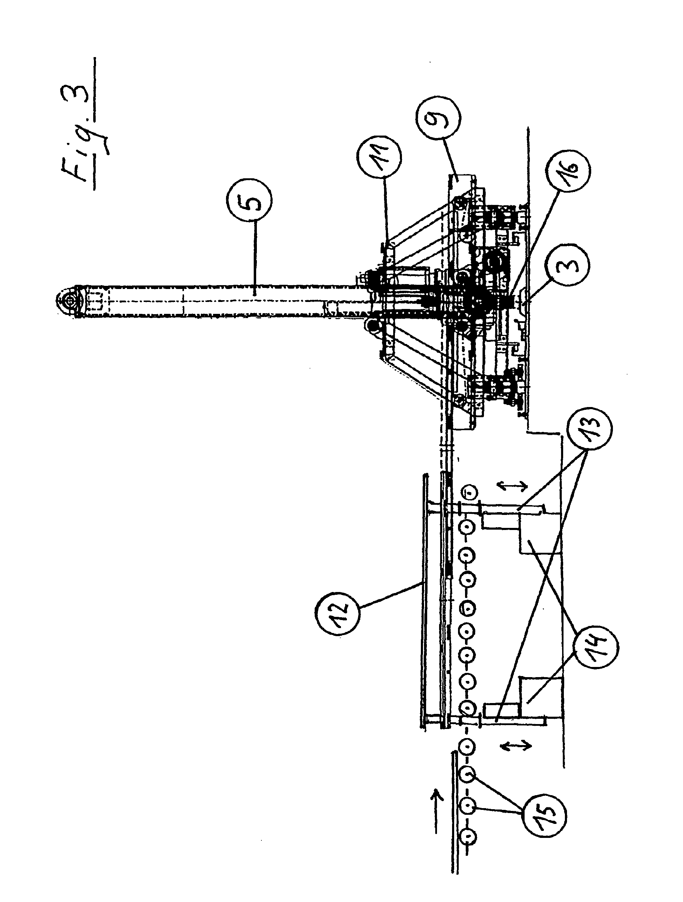

Auf den beiden in Längsrichtung verlaufenden Schienen 2 ist im rechten Bereich die Lafette 1 des, auf den Schienen 2 verfahrbaren, vertikal orientierten Hubportals 5 dargestellt. In dieser Figur 1 ist auf der linken Seite des Hubportals 5 der Hubantrieb 4 zur vertikalen Aufwärtsbewegung und Abwärtsbewegung eines Teleskophubschlittens 11 und einer darauf installierten Teleskopheberplatte 6 zu erkennen. Die Teleskopheberplatte 6 ist zu beiden Seiten des durch die Schienen 2 bestimmten Fahrwegs der Lafette 1 in einem bestimmten Bereich ein - und ausfahrbar. Die jeweilige Arbeitshöhe ist hierbei mittels des Hubantriebs 4 und des Vertikalhubschlittens 11 einstellbar. In der gezeigten Darstellung ist die Teleskopheberplatte 6 zur rechten Seite der rechten Schiene 2 ausgefahren. Das bedeutet, im Vergleich zu dem Sachverhalt der Fig.3, dass sich die Teleskopheberplatte 6 in einer Stellung befindet in der sie eine aufgenommene Glasplatte 12 in einen Speicher oder ein entsprechendes Lager absetzen könnte.

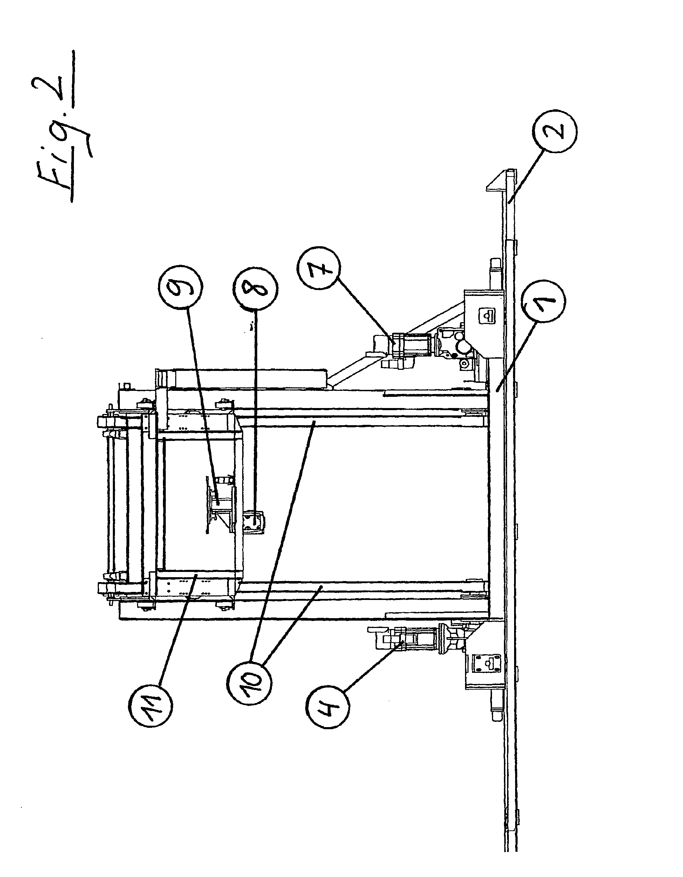

Die Fig.2 zeigt einen ersten Querschnitt des Hubportals 5. Die Ansicht erfolgt hier von derselben Seite wie in der Fig.1. Basierend auf der Lafette 1, die sich auf den Schienen 2 bewegt, sind die beiden, das Hubportal 5 bildenden, Vertikalstützen dargestellt zwischen denen sich der Vertikalhubschlitten 11 bewegen kann. Links und rechts auf den beiden Längsseiten des Vertikalhubschlittens 11 verläuft zu diesem Zweck jeweils ein Zahnriemen 10 parallel an den Innenseiten der Vertikalstützen des Hubportals 5. Der Antrieb dieser beiden Zahnriemen 10 erfolgt mittels des auf der linken Seite der linken Vertikalstütze gezeigten Hubantriebs 4. In der Mitte des Vertikalhubschlittens 11 ist ein Teleskoparm 9 im Querschnitt zu erkennen. Der Teleskoparm 9 wirkt in Verbindung mit der Teleskopheberplatte 6 als Umsetzer für die auf ihm legenden Glasplatten. Der Antrieb 8 für diesen Teleskopumsetzer ist in der Fig.2 unterhalb des Teleskoparms 9 am Vertikalhubschlitten 11 installiert. Auf der rechten Seite der rechten Vertikalstütze ist in der Fig. 2 der Antrieb 7 für die Fahrlafette 1 eingezeichnet.

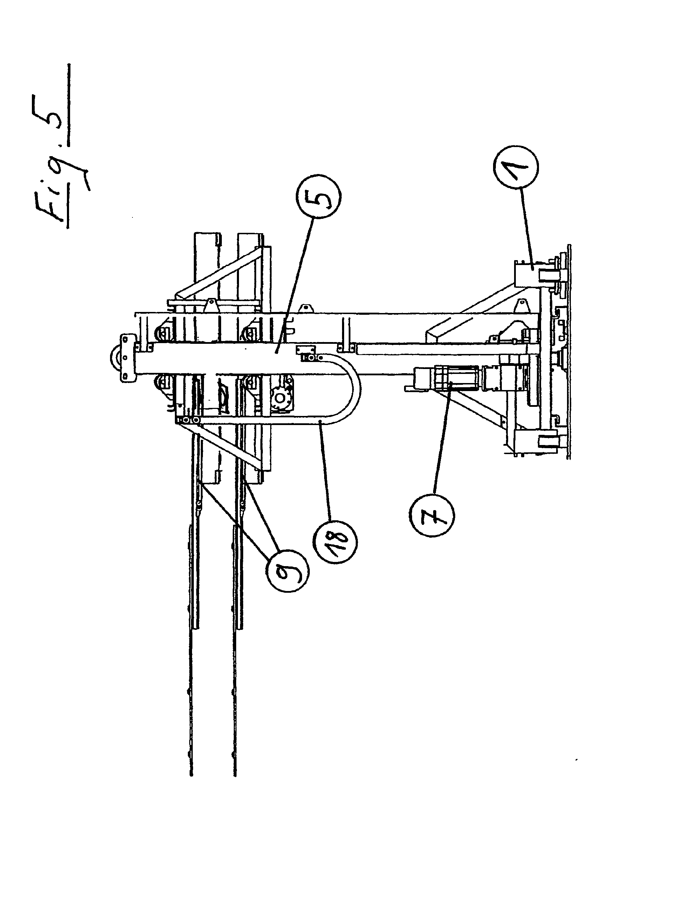

Die Fig. 3 zeigt einen zweiten Querschnitt des Hubportals 5, der eine um 90° gedrehte Darstellung zu der in der Fig. 2 gezeigten bietet. Der Vertikalhubschlitten 11 befindet sich hierbei in einer unteren Position und wird von der Produktionslinie über die Transportrollen 15 mit Glasplatten 12 beliefert. Zu diesem Zweck werden die betreffenden Glasplatten 12 von den Transportrollen 15 auf die gezeigte Übergabevorrichtung befördert. Mittels der verstellbaren Vertikalträger 14 einer Hebeeinrichtung kann die jeweilige Glasplatte 12, geführt an den Vertikalträgern 13 der Übergabevorrichtung, angehoben und / oder abgesenkt werden.
Auf diese Weise dient die Übergabevorrichtung als Zwischenspeicher für die auf einer Fertigungslinie eintreffenden Glasplatten 12. Da gleichzeitig mehrere Glasplatten 12 von der erfindungsgemäßen Vorrichtung abtransportiert werden können ( vgl. Fig. 5) kann die Lafette 1 in der Zeit der Beladung dieses Zwischenspeichers mehrere Glasplatten 12 gleichzeitig zu einem bestimmten Zielort verfahren, abladen, sodann zurückfahren und eine neue Beladung aufnehmen.

Zur Übernahme jeweils einer Glasplatte 12 von der Übergabevorrichtung kann die Teleskopheberplatte 6 mittels des Vertikalhubschlittens 11 für sich jeweils ein kleines Stück abgesenkt und dann, nach dem Darunterfahren der Teleskopheberplatte 6, wieder angehoben werden. Dieser Vorgang erfolgt unabhängig von der jeweiligen Grundstellung der Teleskopheberplatte 6 bevor diese eine Glasplatte 12 aufnimmt. Bei der Ablage in einem bestimmten Speicher erfolgt dieser Vorgang umgekehrt. Im Bereich der Schienen 2 ist in der Fig.3 eine Induktionsschleife 3 als Sender dargestellt der oberhalb im Bereich der Lafette 1 der zugehörige Empfänger 16 für die Energieaufnahme entspricht. Diese kabellose Energieübertragung hat für die Überwindung größerer Entfernungen den Vorteil, dass im Boden größerer Industrieanlagen leicht entsprechende Induktionsspulen mit den entsprechenden Kabeln zur Energiezuführung eingebaut werden können. Die für die elektrische Energiezufuhr normalerweise verwendeten Kabel, die entsprechend der von einer Lafette 1 zurückgelegten Entfernung von einer gesonderten Vorrichtung abgerollt bzw. aufgerollt werden mussten, sind für die Überwindung größerer Entfernungen nicht nur zu unhandlich, sondern sie sind auch störanfällig. Deshalb bietet die erfindungsgemäße Übertragung elektrischer Energie für diesen speziellen Verwendungszweck erhebliche Vorteile.

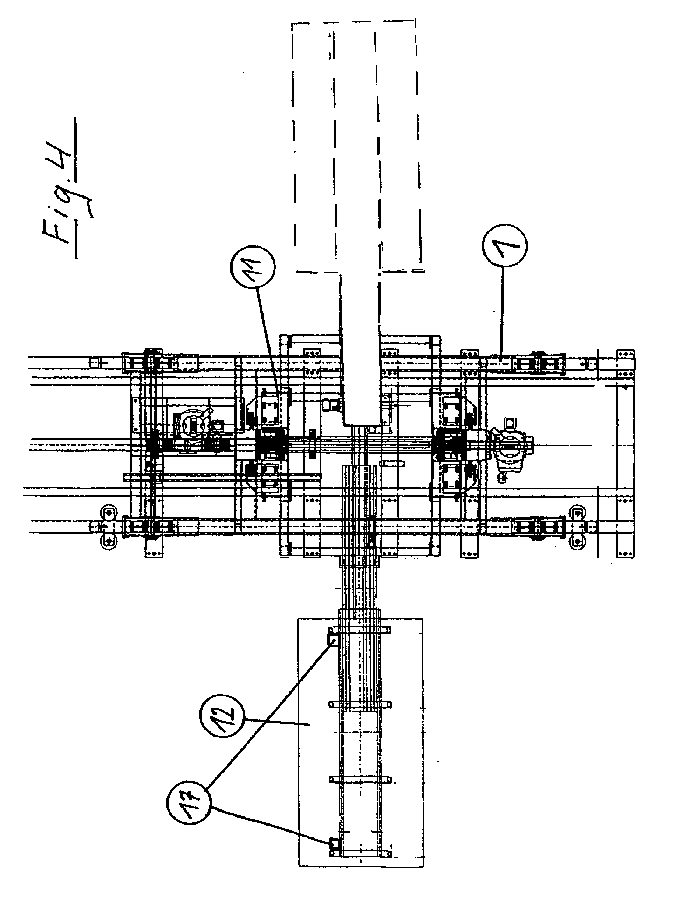

Fig.4 gibt eine Draufsicht auf das Hubportal 5 und die Lageverhältnisse beim Transport von Glasplatten 12 im Querschnitt wieder. Auf der linken Seite der Fig.4 ist, entsprechend der Darstellung in der Fig.3, eine Glasplatte 12, die von einer Produktionslinie angeliefert wurde, auf einer ausgefahrenen Teleskopheberplatte 6 gezeigt. Mittels der hier eingezeichneten Positionssensoren 17 ist hierbei der Vorgang des Ausfahrens und des Durchfahrens einer Teleskopheberplatte 6 zur anderen Seite eines Vertikalhubschlittens 11 steuerbar. In der Mitte des Hubportals 5 ist der Vertikalhubschlitten 11 mit seinen Aggregaten dargestellt. Zur Orientierung ist eine Lafette 1 gezeigt. Auf der rechten Seite der Fig.4 ist eine Teleskopheberplatte 6 im ausgefahrenen Zustand mit einer gestrichelt gezeichneten Glasplatte 12 zum Beladen oder Entladen einer Zielstation gezeigt. Hier ist deutlich zu erkennen, dass die dargestellte Teleskopheberplatte 6 zur Erfüllung ihrer Aufgabe eine Glasplatte 12 von einer Seite eines Vertikalhubschlittens 11 durchgehend zur anderen Seite befördern kann.

Fig.5 zeigt einen Detail -Querschnitt des Hubportals 5 mit einem Vertikalhubschlitten 11 in der obersten Position. In der Fig.5 ist neben einer Schiene 1 und dem Antrieb 7 für die Fahrlafette 1 vor allem zu erkennen, dass zwei Teleskoparme 9 mit jeweils einer aufliegenden Teleskopheberplatte 6 übereinander in einem Vertikalhubschlitten 11 eingebaut sind. Da bisher aus Gründen der Übersicht jeweils nur eine Teleskopheberplatte 6, bzw. ein Teleskoparm 9 gezeigt wurde ist hier verdeutlicht, dass zum schnellen Transport mehrerer Glasplatten 12 mehrere Teleskopheberplatten 6 übereinander angeordnet werden können.
Die Leitung 18 kommt vom Induktionsempfänger 16 und dient der Energieversorgung und der Steuerung der Teleskopvorrichtung. Hierbei können die Steuerungssignale ebenfalls mittels Induktion und / oder per Funk übertragen werden.

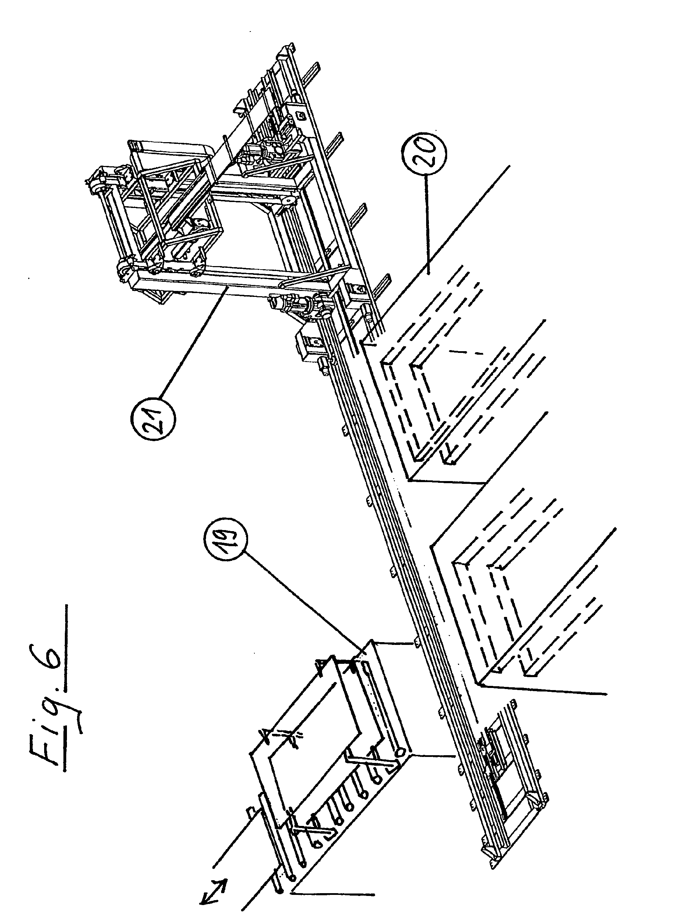

Fig.6 zeigt eine perspektivische Übersichtsdarstellung des Funktionsbereichs einer erfindungsgemäßen Transportvorrichtung. Hier ist die Grundstruktur der in der Fig.1 gezeigten Vorrichtung in einem Fabrikationsbetrieb am Beispiel mit einer Übergabevorrichtung 19 als Zufuhrstation und / oder Abfuhrstation und weiteren Zufuhrstationen und / oder Abfuhrstationen als Sputter- und Beschichtungseinrichtung 20 dargestellt. Die hier gezeigte Teleskopfahr - und Hubeinrichtung 21 ist nur beispielhaft mit lediglich einer Teleskopheberplatte 6 bestückt. In der Übergabevorrichtung 19 und der Einrichtung 20 sind beispielhaft lediglich zwei Stapelebenen eingezeichnet. Es ist hier gut zu erkennen, dass eine Teleskopheberplatte 6 eine Glasplatte 12 durchgehend von einer Seite eines Vertikalhubschlittens 11 zur anderen Seite transportieren kann. Denn anders ist es nicht möglich eine Glasplatte 12 von der Übergabevorrichtung 19 zu der Einrichtung 20 und umgekehrt zu befördern. Es können natürlich in dem jeweils verwendeten Vertikalhubschlitten 11 bis zum Erreichen der Gesamthöhe eines Hubportals 5 zahlreiche Teleskopheberplatten 6 mit den jeweiligen Zusatzaggregaten zum Schnelltransport entsprechender Glasplatten 12 eingebaut werden.

Für die Logistik umfangreicher Fabrikanlagen ist auch der Ausbau einer erfindungsgemäßen Vorrichtung mit Weichen möglich, da eine induktive Energiezuführung leicht ausbaubar ist. Zudem können somit auch gleichzeitig mehrere erfindungsgemäße Vorrichtungen innerhalb eines Logistik - Netzes betrieben werden. Bei einer herkömmlichen Anlage mit einer Energiezuführung mittels Kabel wäre der Betrieb über Weichen - Stellungen nicht möglich.

Die komplexe Steuerung der beschriebenen Bewegungsabläufe erfordert ein spezielles Steuerprogramm.

### Bezugszeichenliste

- (1): Lafette des Hubportals 5
- (2): Schiene
- (3): Induktionsschleife
- (4): Hubantrieb
- (5): vertikales Hubportal
- (6): Teleskopheberplatte
- (7): Antrieb der Fahrlafette 1
- (8): Antrieb des Teleskopumsetzers 6,9
- (9): Teleskoparm
- (10): Zahnriemen des Antriebs des Vertikalhubschlittens
- (11): Vertikalhubschlitten
- (12): Glasplatte
- (13): Vertikalträger der Übergabevorrichtung
- (14): Vertikalträger der Hubeinrichtung der Übergabevorrichtung
- (15): Transportrollen einer Produktionslinie
- (16): Induktionsempfänger
- (17): Positionssensoren
- (18): Energieversorgung und Steuerleitung der Teleskopvorrichtung
- (19): Übergabevorrichtung
- (20): Sputter - und Beschichtungseinrichtung
- (21): Teleskopfahr - und Hubeinrichtung

## Patentansprüche

1. Vorrichtung zum Schnelltransport von Glasplatten zwischen verschiedenen Fertigungs-Stationen in einer großräumigen Fertigungsanlage zur Fertigung von photovoltaischen Elementen, wobei diese Fertigungsanlage Reinraumbedingungen unterliegt,
mit den folgenden Merkmalen:
a) eine frei verfahrbare Lafette (1) zur Beförderung eines Hubportals (5),
b) mindestens einem Vertikalhubschlitten (11) zum vertikalen Transport einer Glasplatte (12) mittels einer Teleskopheberplatte (6), wobei diese nach zwei entgegengesetzten Richtungen ausfahrbar ist, eine lokale Absenkungs- und Anhebungsfunktion aufweist und eine Glasplatte (12) durchgehend von einer Seite eines Vertikalhubschlittens (11) zur anderen Seite transportieren kann, und wobei jeweils ein Vertikalhubschlitten (11) zur Aufnahme mehrerer Teleskopheberplatten (6) ausgestaltet ist,
c) die mechanisch bewegten Teile sind zum Betrieb in einem Reinraum emissionsfrei gekapselt und aus abriebfestem Material gefertigt,
d) eine kabellose Energieversorgung zum Betrieb der Lafette (1),
e) dass in dem durch die Schienen (2) vorgegebenen Transportweg Weichen angebracht sind, die den Zugang zu weiteren Fertigungs-Stationen ermöglichen, wobei die Informationsübertragung und die Energie zum Verstellen einer Weiche induktiv und/oder per Funk erfolgt.

2. Vorrichtung nach einem der vorhergehenden Ansprüche, **dadurch gekennzeichnet,**
**dass** zur Versorgung mehrerer Produktionslinien und/oder mehrerer Fertigungs-Stationen mehrere Lafetten (1) mit jeweils mehreren Vertikalhubschlitten (11) und mehreren Teleskopheberplatten (6) eingesetzt werden.

3. Vorrichtung nach einem der vorhergehenden Ansprüche, **dadurch gekennzeichnet,**
**dass** die Überwachung der Positionierung der Glasplatten (12) über Laser und / oder entsprechende Sensoren, zum Beispiel die Sensoren (17) erfolgt.

4. Vorrichtung nach einem der vorhergehenden Ansprüche, **dadurch gekennzeichnet,**
**dass** eine Übergabevorrichtung (19) als Zwischenspeicher für die auf einer Fertigungslinie eintreffenden Glasplatten (12) dient.

5. Verfahren zum Schnelltransport von Glasplatten zwischen verschiedenen Fertigungs-Stationen in einer großräumigen Fertigungsanlage zur Fertigung von photovoltaischen Elementen, wobei diese Fertigungsanlage Reinraumbedingungen unterliegt,
mit den folgenden Merkmalen:.
a) eine zu befördernde Glasplatte (12) wird jeweils an der jeweiligen Fertigungs- Station mittels einer Teleskopheberplatte (6) aufgenommen oder abgesetzt, wobei vor dem Aufnehmen oder Absetzen eine lokale Absenkungs- und Anhebungsfunktion ausgelöst wird,
b) eine Teleskopheberplatte (6) wird als Bestandteil eines Hubportals (5) über eine Lafette (1) auf Schienen (2) zwischen den jeweiligen Fertigungs-Stationen verfahren, wobei die Teleskopheberplatte (6) als Bestandteil eines Vertikalhubschlittens (11) innerhalb des Hubportals (5) vertikal verfahrbar ist,
c) eine Teleskopheberplatte (6) ist mittels eines Antriebs (8) am Vertikalhubschlitten (11) über einen Teleskoparm (9) in zwei entgegengesetzten Richtungen quer zur Richtung der Schienen (2) verfahrbar, wobei eine Glasplatte (12) durchgehend von einer Seite eines Vertikalhubschlittens (11) zur anderen transportiert werden kann,
d) eine kabellose Energiezuführung zum Betrieb des Hubportals (5) erfolgt im Bereich der Schienen (2) über im Boden verlegte Induktionsschleifen und einen in der Lafette (1) angebrachten Induktionsempfänger (16),
e) dass in dem durch die Schienen (2) vorgegebenen Transportweg Weichen angebracht sind, die den Zugang zu weiteren Fertigungs-Stationen ermöglichen, wobei die Informationsübertragung und die Energiezufuhr zum Verstellen einer Weiche induktiv und/oder per Funk erfolgt.

6. Verfahren nach Anspruch 5,
**dadurch gekennzeichnet,**
**dass** der Vertikalhubschlitten (11) zur Aufnahme mehrerer Teleskopheberplatten (6) ausgestaltet ist.

7. Verfahren nach einem der Ansprüche 5 oder 6,
**dadurch gekennzeichnet,**
**dass** die Überwachung der Positionierung der Glasscheiben (12) über Laser und/oder entsprechende Sensoren (17) erfolgt.

8. Computerprogramm mit einem Programmcode zur Durchführung der Verfahrensschritte nach einem der Ansprüche 6 bis 9, wenn das Programm in einem Computer ausgeführt wird.

9. Maschinenlesbarer Träger mit dem Programmcode eines Computerprogramms zur Durchführung des Verfahrens nach einem der Ansprüche 5 bis 7, wenn das Programm in einem Computer ausgeführt wird.

## Claims

1. Apparatus for the rapid transport of glass sheets between different production stations in a large-scale production plant for producing photovoltaic elements, wherein said production plant is subject to clean room conditions, comprising the following features:
a) a freely movable mount (1) for conveying a lifting gantry (5),
b) at least one vertical lifting carriage (11) for vertically transporting a glass sheet (12) by means of a telescopic jack plate (6), wherein said plate can be extended in two opposite directions, has a local lowering and raising function and can transport a glass sheet (12) continuously from one side of a vertical lifting carriage (11) to the other side, and wherein a respective vertical lifting carriage (11) is configured for receiving a plurality of telescopic jack plates (6),
c) for operation in a clean room, the mechanically moving parts are encapsulated free from emissions and are produced from abrasion-resistant material,
d) a cable-free power supply unit for operating the mount (1),
e) in that switches which allow access to further production stations are fitted in the transport path predefined by the rails (2), wherein the transmission of information and the provision of power for adjusting a switch are effected inductively and/or via radio.

2. Apparatus according to Claim 1,
**characterized**
**in that** a plurality of mounts (1) each with a plurality of vertical lifting carriages (11) and a plurality of telescopic jack plates (6) are used to supply a plurality of production lines and/or a plurality of production stations.

3. Apparatus according to one of the preceding claims,
**characterized**
**in that** the positioning of the glass sheets (12) is monitored using lasers and/or appropriate sensors, for example the sensors (17).

4. Apparatus according to one of the preceding claims,
**characterized**
**in that** a transfer apparatus (19) serves as an intermediate store for the glass sheets (12) arriving on a production line.

5. Method for the rapid transport of glass sheets between different production stations in a large-scale production plant for producing photovoltaic elements, wherein said production plant is subject to clean room conditions,
comprising the following features:
a) a glass sheet (12) to be conveyed is respectively picked up from or put down at the respective production station by means of a telescopic jack plate (6), wherein a local lowering and raising function is initiated before said glass sheet is picked up or put down,
b) as a constituent part of a lifting gantry (5), a telescopic jack plate (6) is moved between the respective production stations via a mount (1) on rails (2), wherein the telescopic jack plate (6) can be moved vertically as a constituent part of a vertical lifting carriage (11) within the lifting gantry (5),
c) a telescopic jack plate (6) can be moved via a telescopic arm (9) in two opposite directions transverse to the direction of the rails (2) by means of a drive (8) on the vertical lifting carriage (11), wherein a glass sheet (12) can be transported continuously from one side of a vertical lifting carriage (11) to the other,
d) power for operating the lifting gantry (5) is supplied without cables in the region of the rails (2) via induction loops laid in the ground and an induction receiver (16) fitted in the mount (1),
e) in that switches which allow access to further production stations are fitted in the transport path predefined by the rails (2), wherein the transmission of information and the supply of power for adjusting a switch are effected inductively and/or via radio.

6. Method according to Claim 5,
**characterized**
**in that** the vertical lifting carriage (11) is configured for receiving a plurality of telescopic jack plates (6).

7. Method according to either one of Claims 5 and 6,
**characterized**
**in that** the positioning of the glass sheets (12) is monitored using lasers and/or appropriate sensors (17).

8. Computer program with a program code for carrying out the method steps according to one of Claims 5 to 7, if the program is executed on a computer.

9. Machine-readable storage medium with the program code of a computer program for carrying out the method according to one of Claims 5 to 7, if the program is executed on a computer.

## Revendications

1. Dispositif de transport rapide de plaques de verre entre différents postes de fabrication d'une installation de fabrication à grande échelle d'éléments photovoltaïques soumise aux spécifications définissant les locaux propres,
le dispositif présentant les caractéristiques suivantes :
a) un affût (1) à déplacement libre destiné à transporter un portail de levage (5),
b) au moins un chariot (11) de lavage vertical qui transporte verticalement une plaque de verre (12) au moyen d'une plaque télescopique de levage (6) pouvant être déployée dans deux directions opposées, présentant une fonction d'abaissement et une fonction de relèvement et pouvant transporter de manière continue une plaque de verre (12) d'un côté à l'autre d'un chariot (11) de levage vertical, chaque chariot (11) de levage vertical étant configuré pour reprendre plusieurs plaques télescopiques de levage (6),
c) pour fonctionner sans émission dans un local propre, les parties déplacées mécaniquement sont encapsulées et réalisées en un matériau résistant à l'abrasion,
d) une alimentation sans fil en énergie est destinée à alimenter l'affût (1),
e) des aiguillages qui permettent l'accès à d'autres postes de fabrication étant installés dans le parcours de transport prédéterminé par les rails (2), le transfert d'informations et de l'énergie de déplacement d'un aiguillage s'effectuant par induction et/ou par radio.

2. Dispositif selon la revendication 1, **caractérisé en ce que** pour alimenter plusieurs lignes de production et/ou plusieurs postes de fabrication, plusieurs affûts (1) qui présentent chacun plusieurs chariots (11) de levage vertical et plusieurs plaques télescopiques de levage (6) sont utilisés.

3. Dispositif selon l'une des revendications précédentes, **caractérisé en ce que** la surveillance du positionnement des plaques de verre (12) s'effectue par laser et/ou par des capteurs appropriés, par exemple les capteurs (17).

4. Dispositif selon l'une des revendications précédentes, **caractérisé en ce qu'**un dispositif de transfert (19) sert de tampon intermédiaire pour les plaques de verre (12) qui entrent dans une ligne de fabrication.

5. Procédé de transport rapide de plaques de verre entre différents postes de fabrication d'une installation de fabrication à grande échelle d'éléments photovoltaïques soumise aux spécifications définissant les locaux propres,
le dispositif présentant les caractéristiques suivantes :
a) une plaque de verre (12) à transporter est reprise ou déposée sur chacun des postes de fabrication au moyen d'une plaque télescopique de levage (6), une fonction locale d'abaissement et de levage étant déclenchée avant la reprise ou la pose,
b) en tant que composant d'un portail de levage (5), une plaque télescopique de levage (6) est déplacée sur des rails (2) par l'intermédiaire d'un affût (1), la plaque télescopique de levage (6) qui fait partie d'un chariot (11) de levage vertical pouvant être déplacée verticalement à l'intérieur du portail de levage (5),
c) un entraînement (8) permet de déplacer une plaque télescopique de levage (6) dans deux directions opposées transversales à la direction des rails (2) sur le chariot (11) de levage vertical par l'intermédiaire d'un bras télescopique (9), une plaque de verre (12) pouvant être transportée de manière continue d'un côté à l'autre d'un chariot (11) de levage vertical,
d) un apport d'énergie sans fil s'effectue au niveau des rails (2) au moyen de boucles d'induction posées dans le sol et d'un récepteur d'induction (16) installé sur l'affût (1) pour alimenter le portail de levage (5) et
e) des aiguillages qui permettent l'accès à d'autres postes de fabrication sont installés dans le parcours de transport défini par les rails (2), le transfert d'informations et l'apport d'énergie pour le déplacement d'un aiguillage s'effectuant par induction et/ou par radio.

6. Procédé selon la revendication 5, **caractérisé en ce que** le chariot (11) de levage vertical est configuré pour reprendre plusieurs plaques télescopiques de levage (6).

7. Procédé selon l'une des revendications 5 ou 6, **caractérisé en ce que** la surveillance du positionnement des plaques de verre (12) s'effectue par laser et/ou par des capteurs (17) appropriés.

8. Programme informatique doté d'un code de programme permettant la mise en oeuvre des étapes du procédé selon l'une des revendications 5 à 7 lorsque le programme est exécuté sur un ordinateur.

9. Support lisible par machine et contenant le code de programme d'un programme informatique permettant la mise en oeuvre du procédé selon l'une des revendications 5 à 7 lorsque le programme est exécuté sur un ordinateur.
